# EUROPEAN PATENT APPLICATION

(11) **EP 4 565 030 A1**
(43) Date of publication of application: **04.06.2025**
(21) Application number: 24216535.5
(22) Date of filing: 29.11.2024
(51) Int. Cl.: H10D 30/67

(54) **SEMICONDUCTOR DEVICE**

(30) Priority: 30.11.2023 KR 20230171824; 25.10.2024 KR 20240147900
(71) Applicant: Samsung Electronics Co., Ltd., Suwon-si, Gyeonggi-do 16677 (KR); IUCF-HYU (Industry-University Cooperation Foundation Hanyang University), Seoul 04763 (KR)
(72) Inventor: LEE, Kwanghee, 16678 Suwon-si (KR); PARK, Jinseong, 04763 Seongdong-gu (KR); KIM, Sangwook, 16678 Suwon-si (KR); CHA, Youngkwan, 16678 Suwon-si (KR); RYU, Seonghwan, 04763 Seongdong-gu (KR); KIM, Hyemi, 04763 Seongdong-gu (KR)
(74) Representative: Elkington and Fife LLP

(57) **Abstract**

Provided are a semiconductor thin film and a semiconductor device including the same. The semiconductor device includes an oxide semiconductor layer having an amorphous phase and including tin (Sn) and a metal element other than tin (Sn), wherein a content of tin (Sn) is greater than 50 at% of a total content of tin (Sn) and the metal element other than tin (Sn), a first electrode and a second electrode disposed on the oxide semiconductor layer and spaced apart from each other, a gate electrode spaced apart from the oxide semiconductor layer, and a gate insulating layer between the oxide semiconductor layer and the gate electrode.

## Description

### FIELD OF THE INVENTION

Various example embodiments relate, in general, to semiconductor thin films including tin and/or semiconductor devices including the semiconductor thin films.

### BACKGROUND OF THE INVENTION

A transistor corresponds to semiconductor device used to switch electrical signals and is used in various integrated circuit devices including a memory, a driving integrated circuit (IC), and a logic device. In order to increase the degree of integration of an integrated circuit device, a space occupied by transistors included in the integrated circuit device has been rapidly reduced, and thus, research has been conducted to reduce the size of a transistor while maintaining the performance thereof.

Oxide semiconductor devices have been studied for years as transparent semiconductor devices having a wide band gap of about 3.0 eV or more. Oxide semiconductor devices used as large-area display driving devices have excellent characteristics such as low off-current and a high on/off ratio. Oxide semiconductor devices having these advantages may be applied to memories or logic devices, or oxide semiconductor devices may be stacked on silicon (Si)-based devices to increase the degree of integration.

However, the performance of oxide semiconductor devices may be degraded due to a short-channel effect caused by scaling down.

### SUMMARY

Provided are oxide semiconductor thin films including tin (Sn) as a component and/or semiconductor devices including the oxide semiconductor thin films.

Alternatively or additionally, provided are oxide semiconductor thin films that may maintain an amorphous phase even at a high temperature and semiconductor devices including the oxide semiconductor thin film.

Additional aspects will be set forth in part in the description which follows and, in part, will be apparent from the description, or may be learned by practice of the presented various example embodiments.

According to an aspect of the disclosure, a semiconductor device includes an oxide semiconductor layer having an amorphous phase and including tin (Sn) and a metal element other than tin (Sn), wherein a content of tin (Sn) is greater than 50 at% of a total content of tin (Sn) and the metal element other than tin (Sn), a first electrode and a second electrode disposed on the oxide semiconductor layer and spaced apart from each other, a gate electrode spaced apart from the oxide semiconductor layer, and a gate insulating layer between the oxide semiconductor layer and the gate electrode.

The metal element other than tin (Sn) may include at least one of indium (In), gallium (Ga), zinc (Zn), aluminum (Al), or hafnium (Hf).

The metal element other than tin (Sn) may include zinc (Zn), wherein a content of zinc (Zn) is 10 at% or less.

In the oxide semiconductor layer, a content of zinc (Zn) may be 0 at%.

The content of tin may be less than 80 at%.

The oxide semiconductor layer may have an amorphous phase at 350°C to 700 °C.

The metal element other than tin (Sn) may include indium, wherein a content ratio of tin to indium is greater than 1 and less than or equal to 4.

A content of indium may is 20 at% or more.

The metal element other than tin (Sn) may include gallium, wherein a content of gallium may be 30 at% or less.

The metal element other than tin (Sn) may include indium (In) and gallium (Ga), wherein a content of gallium may be 30 at% or less.

And, a content of indium may be 20 at% or more.

The oxide semiconductor layer may have Hall mobility of 15 cm²/Vs or more.

The oxide semiconductor layer may have resistivity of 10⁻¹ Ωcm or less.

The oxide semiconductor layer may have a thickness of 20 nm or less.

The gate insulating layer may include at least one of hafnium (Hf), zirconium (Zr), aluminum (Al), and/or silicon (Si).

The gate electrode may include at least one of metal, metal nitride, and/or transparent conductive oxide (TCO).

Alternatively or additionally according to various example embodiments, an oxide semiconductor thin film includes tin (Sn), indium (In), and gallium (Ga), wherein a content of tin is greater than a sum of a content of indium and a content of gallium, and the oxide semiconductor thin film has an amorphous phase.

From among elements excluding oxygen, the content of tin may be greater than 50 at% and less than 80 at%.

From among elements excluding oxygen, the content of gallium may be 30 at% or less.

From among elements excluding oxygen, the content of indium may be 20 at% or more.

### BRIEF DESCRIPTION OF THE DRAWINGS

The above and other aspects, features, and advantages of certain embodiments will be more apparent from the following description taken in conjunction with the accompanying drawings, in which:
FIG. 1 is a graph showing X-ray diffraction (XRD) results for nine types of InSnO thin films, according to some example embodiments;
FIG. 2 is a graph showing a change in carrier concentration, Hall mobility, and resistivity according to a content of tin in InSnO thin films;
FIG. 3 is a graph showing an XRD result after heat-treating the InSnO thin film and the four types of InSnGaO thin films at 400°C for 3 hours in an air atmosphere;
FIG. 4 is a graph showing XRD results after heat-treating the InSnO thin film and the four types of InSnGaO thin films of FIG. 4 at 600°C;
FIG. 5 is a diagram illustrating a change in carrier concentration, Hall mobility, and resistivity according to a content of gallium in the three types of InSnGaO thin films;
FIG. 6 is a diagram illustrating IV characteristics according to a heat treatment temperature of a transistor including an oxide semiconductor thin film, according to some example embodiments;
FIG. 7 is a view illustrating a semiconductor device including an oxide semiconductor, according to some example embodiments;
FIG. 8 is a view illustrating a semiconductor device according to other example embodiments;
FIG. 9 is a view illustrating a semiconductor device according to other example embodiments;
FIG. 10 is a view illustrating a semiconductor device according to other example embodiments;
FIG. 11 is a view illustrating a semiconductor device according to other example embodiments;
FIG. 12 is a circuit diagram illustrating a complementary metal-oxide-semiconductor (CMOS) inverter according to some example embodiments;
FIG. 13 is a circuit diagram illustrating a CMOS static random-access memory (SRAM) device according to some example embodiments;
FIG. 14 is a circuit diagram illustrating a CMOS NAND circuit according to some example embodiments;
FIG. 15 is a block diagram illustrating an electronic system, according to some example embodiments; and
FIG. 16 is a block diagram illustrating an electronic system according to some example embodiments.

### DETAILED DESCRIPTION

Reference will now be made in detail to some example embodiments, examples of which are illustrated in the accompanying drawings, wherein like reference numerals refer to like elements throughout. In this regard, the present various example embodiments may have different forms and should not be construed as being limited to the descriptions set forth herein. Accordingly, the various example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, an oxide semiconductor thin film including tin and a semiconductor device including the oxide semiconductor thin film according to various example embodiments will be described in detail with reference to the attached drawings. Like reference numerals denote like elements throughout, and in the drawings, sizes of elements may be exaggerated for clarity and convenience of explanation.

The singular forms "a," "an," and "the" are intended to include the plural forms as well, unless the context clearly indicates otherwise. When a part "includes" an element, another element may be further included, rather than excluding the existence of the other element, unless otherwise described. Sizes or thicknesses of elements may be exaggerated for clarity of explanation. It will also be understood that when a material layer is referred to as being "on" another layer or a substrate, the material layer may be directly on the other layer or the substrate, or intervening layers may also be present therebetween. A material of each layer in the following various example embodiments is merely an example, and thus, other materials may be used.

Also, in the specification, the term "... unit" or "module" indicates a unit for processing at least one function or operation, and may be implemented by hardware, software, or a combination of hardware and software.

Specific executions described in the present various example embodiments are examples and are not intended to limit the scope of the disclosure in any way. For the sake of brevity, conventional electronics, control systems, software, and other functional aspects of the systems may not be described in detail.

Also, lines or members connecting elements illustrated in the drawings are merely illustrative of functional connections and/or physical or circuit connections. In an actual device, the connections between elements may be represented by many alternative or additional functional connections, physical connections, or circuit connections.

The use of the terms "a", "an," and "the" and similar referents in the context of describing the disclosure is to be construed to cover both the singular and the plural.

The expression "at least one" preceding a list of elements is to limit the entire list of elements and does not limit individual elements of the list. For example, the expression "at least one of A, B, and C" or "at least one selected from the group consisting of A, B, and C" may indicate only A, only B, only C, or a combination thereof (e.g., ABC, AB, BC, or AC).

When "about" or "substantially" is used in connection with a numerical value, the relevant numerical value may include a manufacturing or operational tolerance (e.g., ±10%) around the stated numerical value. Also, when the term "generally" or "substantially" is used in connection with a geometric shape, it may be intended that precision of the geometric shape is not required and latitude for the shape is within the scope of the disclosure. Also, regardless of whether a numerical value or a shape is limited by "about" or "substantially", the numerical value or the shape should be construed to include a manufacturing or operational tolerance (e.g., ±10%) around the stated numerical value.

It will be understood that although the terms "first," "second," etc. may be used herein to describe various elements, these elements should not be limited by these terms. These terms are used only to distinguish one element from another.

One or more of the elements disclosed below may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

The use of any and all examples or exemplary language provided herein is intended merely to better describe the disclosure and does not pose a limitation on the scope of the disclosure unless otherwise claimed.

Oxide semiconductors have excellent characteristics such as low off-current, low subthreshold swing, and a high on/off ratio and may thus be used in memory devices or logic devices.

An oxide semiconductor thin film according to some example embodiments may include an oxide semiconductor that has an amorphous phase and includes a plurality of metal elements wherein a content of tin (Sn) from among the plurality of metal elements is the largest. The oxide semiconductor may further include, in addition to tin, indium (In), gallium (Ga), zinc (Zn), aluminum (Al), and hafnium (Hf). For example, the oxide semiconductor may be or may include InSnO, InGaSnO, InSnZnO, GaSnZnO, or ZnSnO. The thickness of the oxide semiconductor thin film according to various example embodiments may be about 30 nm or less, about 20 nm or less, or about 10 nm or less.

Tin (Sn) has a 5-s orbital and thus, has a high electron mobility. However, because tin has high bond dissociation energy with oxygen of about 528 kJ/mol, tin may reduce oxygen diffusion. Accordingly, even when heat is applied to the oxide semiconductor, metal ions may maintain a thermally stable state by reducing a composition change and may maintain electrical properties. However, because tin has high bond dissociation energy with oxygen, the probability of forming oxygen vacancies is low and thus, charge carrier concentration may be low. To complement the above characteristics, an element having low bond dissociation energy with oxygen may be added to oxide including tin.

Even when the oxide semiconductor thin film includes a plurality of different elements excluding oxygen, a content of tin from among the plurality of elements may be greater than or equal to about 50 at%, greater than or equal to about 53 at%, less than or equal to about 69 at%, less than or equal to about 75 at%, less than about 80 at%, and less than about 85 at%. Here, the term "content" may refer to a content among metal elements excluding oxygen.

The oxide semiconductor thin film may include tin (Sn) and a first metal element X different from tin. The first metal element X may be any one of indium (In), gallium (Ga), zinc (Zn), aluminum (Al), and hafnium (Hf). A content ratio of tin to the first metal element may be greater than about 1 and less than or equal to 4.

Indium (In) has low bond dissociation energy with oxygen, and thus, it may easily form oxygen vacancies to increase charge carrier concentration in oxide and may well form an electron conduction path through a 5-s orbital.

InSnO, a combination of indium and tin, is widely used as an electrode due to its high charge carrier concentration and/or electron mobility, but when the thickness of oxide is lowered, InSnO may have semiconductor properties and may be used as a channel. In the oxide semiconductor thin film, a content of indium may be greater than or equal to 20 at% and less than about 50 at%.

The oxide semiconductor thin film may further include gallium (Ga). The oxide semiconductor thin film including gallium may maintain an amorphous phase better than an oxide semiconductor thin film not including gallium. However, carrier concentration decreases in proportion to a content of gallium. When the content of gallium is too high, the thin film may have insulating properties, and thus, the content of gallium needs to be limited. For example, the content of gallium may be 30 at% or less.

On the other hand, zinc (Zn) is a thermally unstable material. A recrystallization temperature of zinc is about 50°C or lower. Zinc may be recrystallized even by heat of about 200°C to about 300°C, thereby changing electrical properties of the thin film. Also, zinc has a problem in that a diffusion rate of zinc is increased by heat and zinc may diffuse into other materials such as an insulating layer, thereby increasing the conductivity of the insulating layer. The oxide semiconductor thin film according to some example embodiments may maintain semiconductor properties by reducing a content of zinc (Zn).

When the semiconductor thin film according to some example embodiments includes zinc (Zn), a content of zinc may be about 30 at% or less or about 10 at% or less. Alternatively, the content of zinc may be about 0 at%.

The oxide semiconductor thin film may include tin and a first element and a second element different from tin. A content of tin may be greater than a sum of a content of the first element and a content of the second element. Each of a content of the first element and a content of the second element may be about 30 at% or less. For example, when the oxide semiconductor thin film further includes indium and gallium, a content of tin may greater than a sum of a content of indium and a content of gallium. In this case, the content of gallium may be about 30 at% or less or the content of indium may be about 30 at% or less. The content of indium may be about 20 at% or more. Alternatively, when the oxide semiconductor thin film includes indium and zinc, a content of tin may be greater than a sum of a content of indium and a content of zinc. The content of indium may be about 20 at% or more, or the content of zinc may be about 30 at% or less. The oxide semiconductor thin film may include four or more types of metals including tin.

In order to identify electrical properties of the oxide semiconductor thin film including tin and indium, a total of 9 types of thin films including an In₂O₃ thin film, a SnO₂ thin film, and 7 types of InSnO thin films were manufactured along a line connecting indium and tin. Composition ratios of indium and tin in the 7 types of InSnO thin films were 0.15: 0.85, 0.31: 0.69, 0.47: 0.53 0.63: 0.37, 0.75: 0.25, 0.80: 0.20, and 0.84: 0.16, respectively. The thickness of each thin film was about 30 nm. The nine types of thin films were heat-treated at 400°C for 3 hours in an air atmosphere, and then X-ray diffraction (XRD), carrier concentration, Hall mobility, and resistivity were measured.

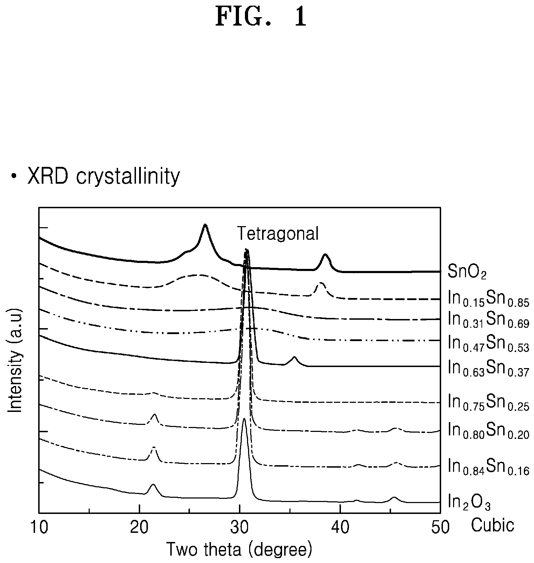

FIG. 1 is a graph showing XRD results for the nine types of InSnO thin films , according to various example embodiments.

Referring to FIG. 1, it is found that crystallinity changed according to a content of indium and tin. For example, in XRD analysis, the SnO₂ thin film had a peak when a 2-theta value was about 27 degrees and about 38.5 degrees. This may mean that the SnO₂ thin film had a tetragonal phase. It is found that the In₂O₃ thin film had a peak when a 2-theta value was about 31 degrees. This may mean that the In₂O₃ thin film had a cubic phase.

When In₂O₃ was added to SnO₂, it is found that in the InSnO thin film in which a content of indium was 15 at%, a peak became broad when a 2-theta value was about 27 degrees and a peak at about 38.5° degrees changed to a peak at 38.1 degrees. Accordingly, the position and shape of a peak slightly changed but there was still a peak. This may mean the InSnO thin film in which a content of indium was 15 at% had poly-crystallinity with a tetragonal phase. It is found that even in the InSnO thin film in which a content of tin was about 37 at% by adding SnO₂ to In₂O₃, the position of a peak slightly changed but there was still a sharp peak around 31°. This may mean that the InSnO thin film in which a content of tin was about 37 at% or less had poly-crystallinity with a cubic phase.

It may be found that the InSnO thin films having a composition In:Sn=47:53 and a composition In:Sn=31:69 did not have a sharp peak. For example, it may be found that the InSnO thin film in which a content of tin was about 53 at% to 69 at% had an amorphous phase.

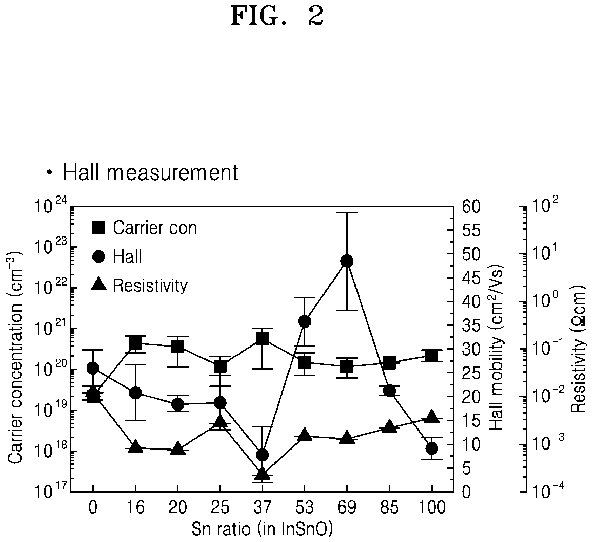

FIG. 2 is a graph showing a change in carrier concentration, Hall mobility, and resistivity according to a content of tin in InSnO thin films.

Referring to FIG. 2, it is found that Hall mobility rapidly changed according to a change in a content of tin. In particular, it is found that when a content of tin was greater than 50 at% and less than or equal to 80 at%, Hall mobility was 30 cm²/Vs or more and resistivity was 10⁻³ Ωcm or more and 10⁻¹ Ωcm or less. It is found that the InSnO thin film in which a content of tin was greater than 50 at% and less than 80 at% had semiconductor properties with high Hall mobility.

Considering a mechanism of an oxide semiconductor in which electrons move through s orbitals, when indium and tin are mixed in an amorphous state, electrons may move freely through s orbitals. However, when an InSnO thin film has a poly-crystalline phase, electron mobility may be reduced due to grain boundary scattering. Accordingly, an oxide semiconductor thin film that has an amorphous phase when tin and indium are combined so that a content of Sn is greater than about 50 at% and less than about 80 at% may have high Hall mobility.

It is found that because the InSnO thin film in which a content of tin was greater than about 50 at% and less than about 80 at% maintained an amorphous phase and high Hall mobility even when heat-treated at 400°C for 3 hours, the InSnO thin film had high thermal stability at 400°C.

The oxide semiconductor thin film including tin as a main component according to some example embodiments may further include at least one of gallium (Ga), zinc (Zn), aluminum (Al), and hafnium (Hf). In general, gallium may increase thermal stability of the semiconductor thin film. Because a diffusion rate of zinc (Zn) is increased by heat, a content of zinc may be 10 at% or less.

In order to identify electrical properties of the oxide semiconductor layer including indium, tin and gallium, four types of InSnGaO thin films in which a composition ratio of In: Sn:Ga was about 25: 58: 17, about 20: 52: 28, about 17: 46: 37, and about 16: 42: 42 were manufactured by an atomic layer deposition (ALD).

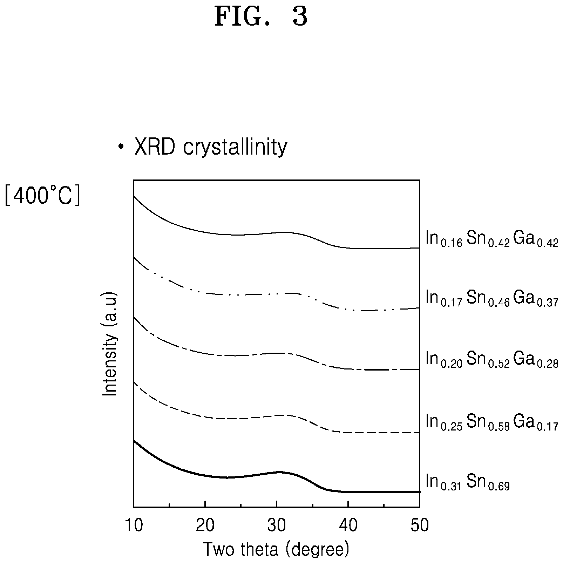

FIG. 3 is a graph showing an XRD result after heat-treating the InSnO thin film and the four types of InSnGaO thin films at 400°C for 3 hours in an air atmosphere.

Referring to FIG. 3, as a result of checking crystallinity using XRD, a peak was not found when a 2-theta value was about 27 degrees, about 31 degrees, and about 38.5 degrees. It is found that even when gallium was included, the four types of InSnGaO maintained an amorphous phase.

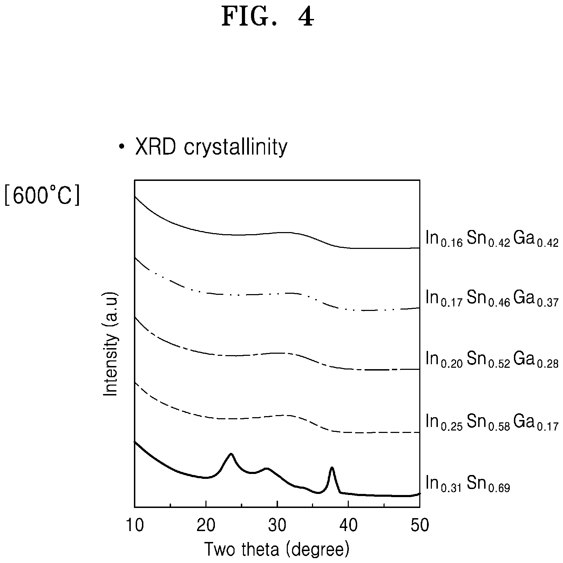

FIG. 4 is a graph showing XRD results after heat-treating the InSnO thin film and the four types of InSnGaO thin films at 600°C, according to various example embodiments.

Referring to FIG.4, as a result of checking crystallinity using XRD, in the InSnO thin film (ITO) not including gallium, a peak was found when a 2-theta value was about 24 degrees and about 38.5 degrees. This may mean that the InSnO thin film may have a poly-crystalline phase when heat-treated even at a high temperature such as about 600°C. However, in the four types of InSnGaO thin films including gallium, a peak was not found. This may mean that the InSnGaO thin films ensured thermal stability due to gallium.

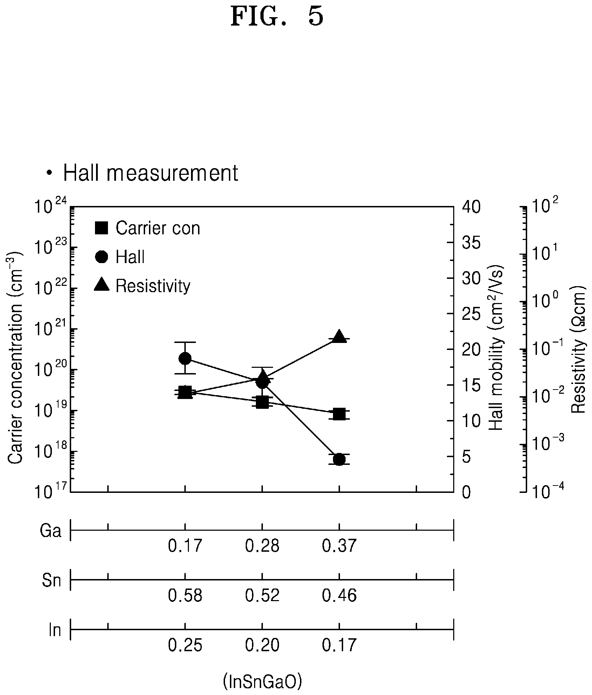

FIG. 5 is a diagram illustrating a change in carrier concentration, Hall mobility, and resistivity according to contents of gallium, tin, indium in the three types of InSnGaO thin films, according to various example embodiments. FIG. 5 shows a result for the three types of InSnGaO thin films in which a composition ratio of In: Sn:Ga was about 25: 58: 17, about 20: 52: 28, and about 17: 45: 37.

Referring to FIG. 5, it is found that a content of tin decreased, a content of gallium increased, carrier concentration and Hall mobility decreased, and resistivity increased. It is found that when a content of tin was about 50 at% or less or a content of gallium was greater than about 30 at%, Hall mobility decreased or resistivity increased. This may mean that electrical properties of the oxide semiconductor thin film are related to contents of tin and gallium. When a content of tin is greater than a sum of contents of indium and gallium, Hall mobility is 15 cm²/Vs or more and resistivity is 10⁻¹ Ωcm or less, and thus, semiconductor properties may be exhibited. When a content of tin is greater than about 50 at% or a content of gallium is about 30 at% or less, Hall mobility is 15 cm²/Vs or more and resistivity is 10⁻¹ Ωcm or less, and thus, semiconductor properties may be exhibited

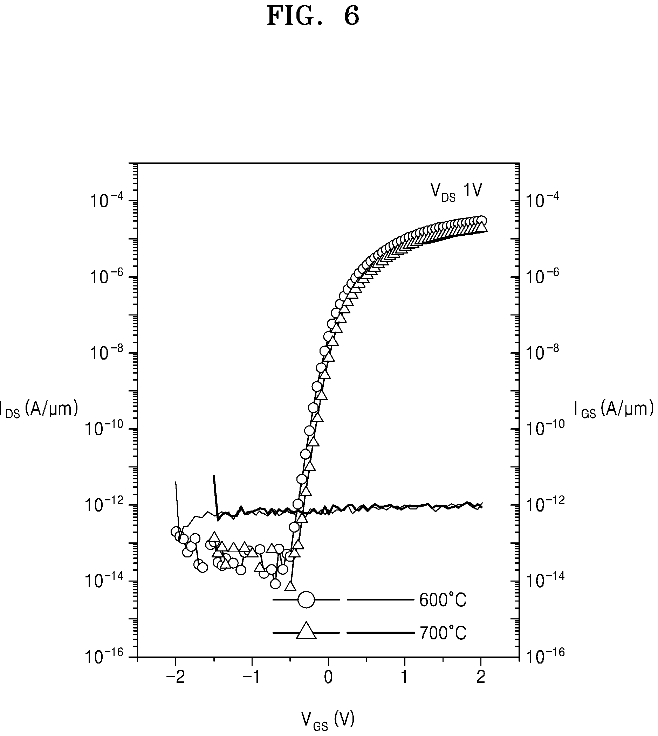

FIG. 6 is a diagram illustrating IV characteristics according to a heat treatment temperature of a transistor including an oxide semiconductor thin film, according to some example embodiments. An oxide semiconductor thin film having a composition ratio of In:Sn:Ga of 0.25:0.64:0.11 was formed as a channel layer with a thickness of about 4.5 nm, and then heat-treated at about 600°C and about 700°C for about 30 minutes. FIG. 6 illustrates IV characteristics of transistors heat-treated at different temperatures.

Referring to FIG. 6, it was found from the IV characteristics of the transistor heat-treated at about 600°C that the transistor heat-treated at about 600°C has a threshold voltage of about -0.2 V and has a field-effect mobility of about 7.7 cm²Ns at a sub-threshold voltage swing of 75 mV/dec. It was found that the transistor heat-treated at 600°C has excellent thermal stability.

It was found from the IV characteristics of the transistor heat-treated at about 700°C that the transistor heat-treated at about 700°C has a threshold voltage of about -0.1 V and a field-effect mobility of about 5.2 cm²/Vs at a sub-threshold voltage swing of about 86 mV/dec. It was found that the transistor heat-treated at about 700°C may still operate stably even though its thermal stability is slightly deteriorated compared to the transistor heat-treated at 600°C.

An oxide semiconductor thin film including tin as a main component according to various example embodiments may have semiconductor properties due to high Hall mobility and may thus be used as a channel layer of as a semiconductor device.

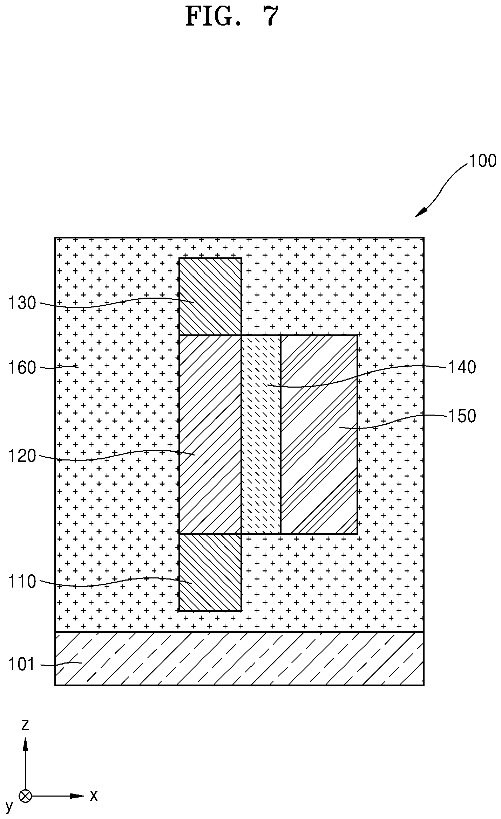

FIG. 7 is a view illustrating a semiconductor device including an oxide semiconductor, according to some example embodiments. Referring to FIG. 7, a semiconductor device 100 may include a substrate 101, a first electrode 110 disposed on the substrate 101, an oxide semiconductor layer 120 disposed on the first electrode 110, and a second electrode 130 disposed on the oxide semiconductor layer 120.

The substrate 101 may be or may include an insulating substrate, or a semiconductor substrate having a surface on which an insulating layer is formed. Alternatively, the substrate 101 may be or may include a semiconductor substrate. The semiconductor substrate may include, for example, Si, Ge, SiGe, or a group III-V semiconductor material. The substrate 101 may be, for example, a silicon substrate having a surface on which silicon oxide is formed, but the disclosure is not limited thereto.

The first electrode 110 may include a metal material. The first electrode 110 may include at least one selected from the group selected from among tungsten (W), cobalt (Co), nickel (Ni), iron (Fe), titanium (Ti), molybdenum (Mo), chromium (Cr), zirconium (Zr), hafnium (Hf), niobium (Nb), tantalum (Ta), silver (Ag), gold (Au), aluminum (Al), copper (Cu), tin (Sn), Antimony(Sb), vanadium (V), ruthenium (Ru), platinum (Pt), zinc (Zn), and/or magnesium (Mg). The first electrode 110 may be spaced apart from the substrate 101.

The oxide semiconductor layer 120 may be provided as an ultra-thin film. For example, the thickness of the oxide semiconductor layer 120 may be about 30 nm or less, about 20 nm or less, or about 10 nm or less. The length of the oxide semiconductor layer 120 may be less than about 1 µm. The oxide semiconductor layer 120 may be an oxide semiconductor thin film including tin as a main component as described above. For example, the oxide semiconductor layer 120 may include a plurality of elements excluding oxygen and may have an amorphous phase, wherein a content of tin (Sn) from among the plurality of elements is the largest. A content of tin may be greater than about 50 at%, greater than or equal to about 53 at%, less than or equal to about 75 at%, and less than about 80 at%. Here, the term "content" may refer to a content among elements excluding oxygen in the oxide semiconductor layer 120.

The oxide semiconductor layer 120 may include any one of indium (In), gallium (Ga), zinc (Zn), aluminum (Al), and hafnium (Hf). For example, when the oxide semiconductor layer 120 further includes indium, a content ratio of tin to indium may be greater than about 1 and less than or equal to 4. In the oxide semiconductor layer 120, a content of indium may be greater than or equal to about 20 at% and less than about 50 at%. The oxide semiconductor layer 120 may further include gallium whose content is 30 at% or less. Alternatively, when the oxide semiconductor layer 120 further includes indium and gallium, a content of tin may be greater than a sum of a content of indium and a content of gallium. In this case, the content of gallium may be about 30 at% or less, or the content of indium may be about 30 at% or less. The content of indium may be about 20 at% or more. The oxide semiconductor layer 120 may maintain an amorphous phase at a temperature of about 350°C to 700°C or about 350°C to 600°C.

The oxide semiconductor layer 120 may be disposed so that the longitudinal direction of the oxide semiconductor layer 120 is a direction (z-axis direction) perpendicular to the substrate 101. In the specification, the term "longitudinal direction" refers to a direction in which a length of a corresponding element is long when viewed in the drawing.

The second electrode 130 may be disposed on the oxide semiconductor layer 120. The first electrode 110 and the second electrode 130 may be spaced apart from each other in the direction (z-axis direction) perpendicular to the substrate 101. For example, the first electrode 110, the oxide semiconductor layer 120, and the second electrode 130 may be aligned with each other in the direction perpendicular to the substrate 101 or the thickness direction (z-axis direction) of the first electrode 110.

A gate electrode 150 may be disposed at one side of the oxide semiconductor layer 120. A gate insulating layer 140 may be disposed between the oxide semiconductor layer 120 and the gate electrode 150. The gate electrode 150 may include at least one of metal, metal nitride, and transparent conductive oxide (TCO). The gate insulating layer 140 may include an oxide including at least one of hafnium (Hf), zirconium (Zr), aluminum (Al), and/or silicon (Si).

The gate electrode 150 may be disposed so that the longitudinal direction (z-axis direction) of the gate electrode 150 is the direction perpendicular to the substrate 101. The oxide semiconductor layer 120, the gate insulating layer 140, and the gate electrode 150 may be aligned with each other in a direction (x-axis direction) parallel to the substrate 101.

A mold insulating layer 160 may be disposed on the substrate 101 to fill an empty space. The first electrode 110 may be spaced apart from the substrate 101 by the mold insulating layer 160.

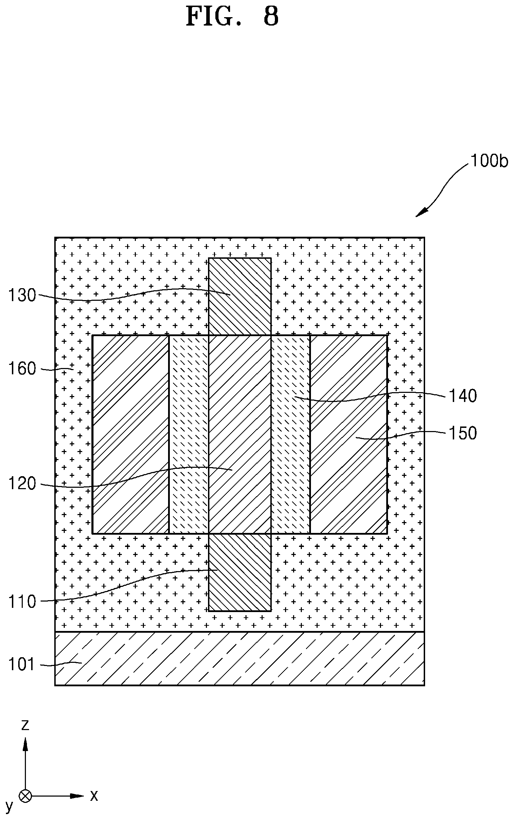

FIG. 8 is a view illustrating a semiconductor device 100b according to other example embodiments. In FIG. 8, elements denoted by the same reference numerals as those in FIG. 7 have substantially the same configuration and effect as those described with reference to FIG. 7 and thus, a detailed description thereof is omitted.

The semiconductor device 100b of FIG. 8 may include the first electrode 110, the oxide semiconductor layer 120, and the second electrode 130 arranged in the direction (z-axis direction) perpendicular to the substrate 101. The gate insulating layer 140 may be disposed around the oxide semiconductor layer 120, and the gate electrode 150 may be disposed around the gate insulating layer 140. The gate electrode 150 may be disposed around the oxide semiconductor layer 120 so that an area where the gate electrode 150 and the oxide semiconductor layer 120 face each other is increased and a short-channel effect is suppressed.

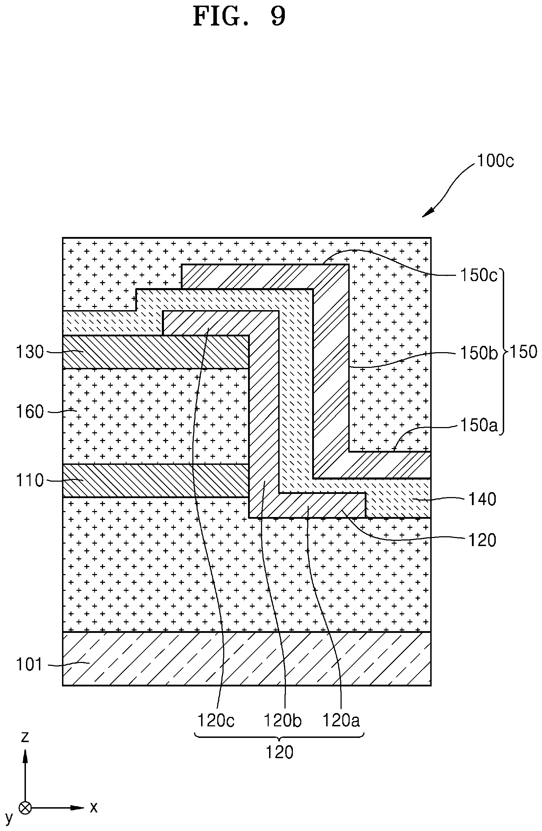

FIG. 9 is a view illustrating a semiconductor device 100c according to another example embodiments.

Referring to FIG. 9, the semiconductor device 100c may include the substrate 101, the first electrode 110 disposed on the substrate 101, and the second electrode 130 spaced apart from the first electrode 110. The first electrode 110 and the second electrode 130 may be spaced apart from each other in the direction (z-axis direction) perpendicular to the substrate 101.

The oxide semiconductor layer 120 may be disposed outside a space between the first electrode 110 and the second electrode 130. The oxide semiconductor layer 120 may include a first portion 120a parallel to the substrate 101, a second portion 120b extending bent from the first portion 120a in the direction perpendicular to the substrate 101, and a third portion 120c extending bent from the second portion 120b in a direction opposite to the first portion 120a. The second portion 120b may be disposed on sides of the first electrode 110 and the second electrode 130, and the third portion 120c may contact the second electrode 130. The oxide semiconductor layer 120 may correspond to an oxide semiconductor thin film described above.

The gate electrode 150 may have a similar shape to the oxide semiconductor layer 120 and may be spaced apart from the oxide semiconductor layer 120. In other words, the gate electrode 150 may include a first portion 150a parallel to the substrate 101, a second portion 150b extending bent from the first portion 150a in the direction perpendicular to the first substrate 101, and a third portion 150c extending bent from the second portion 150b in the direction opposite to the first portion 150a. The gate insulating layer 140may be disposed between the oxide semiconductor layer 120 and the gate electrode 150.

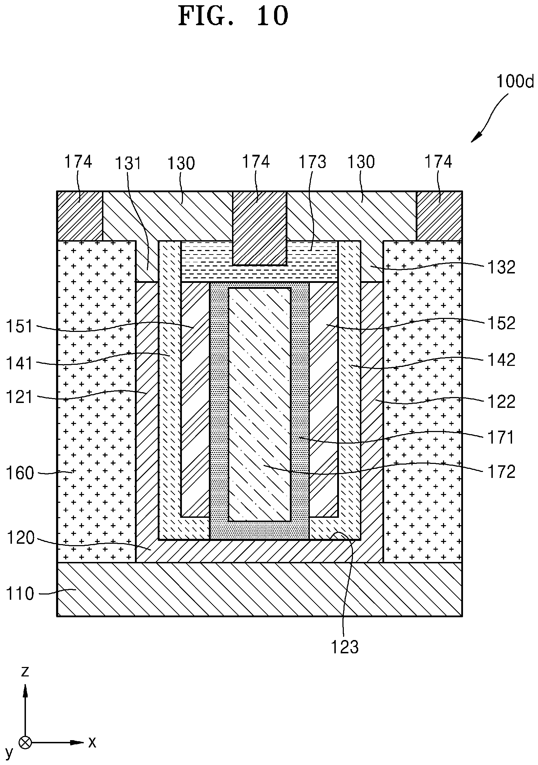

FIG. 10 is a view illustrating a semiconductor device 100d according to some example embodiments.

The semiconductor device 100d of FIG. 10 may include the first electrode 110 and the oxide semiconductor layer 120 disposed on the first electrode 110. Materials of the first electrode 110 and the oxide semiconductor layer 120 have been described above, and thus, a detailed description thereof is omitted.

The oxide semiconductor layer 120 may have a U-shaped cross-sectional shape. The oxide semiconductor layer 120 may include a bottom portion 123 contacting the first electrode 110, a first vertically extending portion 121 extending from one end of the bottom portion 123 in a direction (z-axis direction) perpendicular to the first electrode 110, and a second vertically extending portion 122 extending from the other end of the bottom portion 123 in the direction (z-axis direction) perpendicular to the first electrode 110.

A first gate electrode 151 may be spaced apart from the first vertically extending portion 121, and a second gate electrode 152 may be spaced apart from the second vertically extending portion 122. A first gate insulating layer 141 may be disposed between the first vertically extending portion 121 and the first gate electrode 151, and a second gate insulating layer 142 may be disposed between the second vertically extending portion 122 and the second gate electrode 152.

The first gate electrode 151 and/or the second gate electrode 152 may extend in a second horizontal direction (y-axis direction). The first gate electrode 151 and the second gate electrode 152 may be spaced apart from each other. For example, the first gate electrode 151 and the second gate electrode 152 may be spaced apart in a first horizontal direction (x-axis direction). The first gate electrode 151 and/or the second gate electrode 152 may constitute a word line WL. An electrical signal input to the first gate electrode 151 may not be the same as an electrical signal input to the second gate electrode 152. The first gate electrode 151 may control a channel of the first vertically extending portion 121, and the second gate electrode 152 may control a channel of the second vertically extending portion 122.

An insulating liner 171 may be disposed between the first gate electrode 151 and the second gate electrode 152 spaced apart from each other. The insulating liner 171 may be conformally disposed on opposing side walls of the first gate electrode 151 and the second gate electrode 152 and/or a top surface of the oxide semiconductor layer 120. For example, the insulating liner 171 may be conformally disposed on a top surface of the bottom portion 123. The insulating liner 171 may have a top surface that is disposed on the same plane as a top surface of the first gate electrode 151 and the second gate electrode 152. The insulating liner 171 may include, for example, silicon nitride. A buried insulating layer 172 may be disposed on the insulating liner 171 to fill a space between the first gate electrode 151 and the second gate electrode 152 spaced apart from each other. The buried insulating layer 172 may include, for example, silicon oxide. An upper insulating layer 173 may be disposed on a top surface of the first gate electrode 151, the second gate electrode 152, and/or the buried insulating layer 172. A top surface of the upper insulating layer 173 may be at the same level as a top surface of the mold insulating layer 160.

The second electrode 130 may be disposed on the oxide semiconductor layer 120. The second electrode 130 may function as a landing pad. The second electrode 130 may include a first sub-electrode 131 and a second sub-electrode 132. The first sub-electrode 131 may be electrically connected to the first vertically extending portion 121. The second sub-electrode 132 may be electrically connected to the second vertically extending portion 122. The first sub-electrode 131 and the second sub-electrode 132 may not be electrically connected to each other.

The second electrode 130 may include an upper portion and a lower portion. The upper portion of the second electrode 130 may be a portion of the second electrode 130 disposed at a higher level than the top surface of the mold insulating layer 160. The lower portion of the second electrode 130 may be a portion of the second electrode 130 disposed in a recess of the second electrode 130 defined between the mold insulating layer 160 and the upper insulating layer 173.

In some example embodiments, the upper portion of the second electrode 130 may have a first width in a first horizontal direction (x-axis direction), and the lower portion of the second electrode 130 may have a second width that is less than the first width in the first horizontal direction (x-axis direction). The lower portion of the second electrode 130 may be disposed in the recess of the second electrode 130, and the upper portion of the second electrode 130 may be disposed on the lower portion of the second electrode 130 and may have a bottom surface disposed on the top surface of the mold insulating layer 160 and the top surface of the upper insulating layer 173, and thus, the second electrode 130 may have a T-shaped vertical cross-sectional shape.

A bottom surface of the lower portion of the second electrode 130 may contact a top surface of the first vertically extending portion 121 and/or the second vertically extending portion 122. For example, a bottom surface of the first sub-electrode and/or a bottom surface of the second sub-electrode may contact a top surface of the first vertically extending portion 121 and/or the second vertically extending portion 122. Both side walls of the lower portion of the second electrode 130 may be aligned with both side walls of the first vertically extending portion 121 and the second vertically extending portion 122. The bottom surface of the lower portion of the second electrode 130 may be at a higher level than the top surface of the first gate electrode 151 and/or the second gate electrode 152, and a portion of a side wall of the lower portion of the second electrode 130 may be covered by the first gate insulating layer 141 and/or the second gate insulating layer 142.

An insulating layer 174 surrounding the second electrode 130 may be disposed on the top surfaces of the mold insulating layer 160 and the upper insulating layer 173. The semiconductor device 100d may have a vertical channel transistor (VCT) structure including a vertical channel region extending in the direction z-axis direction perpendicular to the first electrode 110.

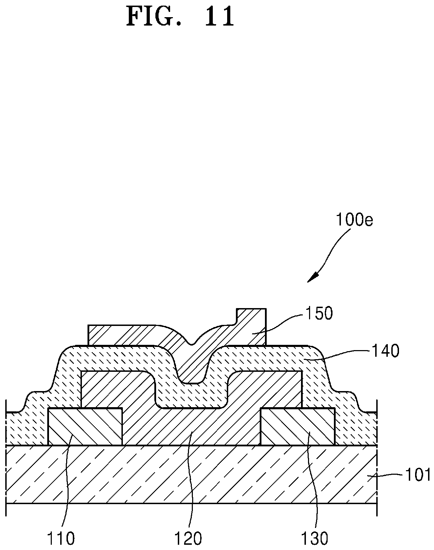

FIG. 11 is a view illustrating a semiconductor device 100e according to other example embodiments. Referring to FIG. 11, the semiconductor device 100e may include the substrate 101, and the first electrode 110 and the second electrode 130 disposed on the substrate 101 and spaced apart from each other. The first electrode 110 and the second electrode 130 may be spaced apart from each other in a direction (x-axis direction) parallel to the substrate 101.

The oxide semiconductor layer 120 may be disposed between the first electrode 110 and the second electrode 130. The oxide semiconductor layer 120 may include a first portion parallel to the substrate 101, a second portion extending bent from the first portion in a direction perpendicular to the first substrate 101, and a third portion extending bent from the second portion in a direction opposite to the first portion. For example, the second portion may be spaced apart from the third portion. The second portion may overlap a portion of the first electrode 110 in the thickness direction of the substrate 101, and the third portion may overlap a portion of the second electrode 130 in the thickness direction of the substrate 101. For example, the second portion may overlap a portion of the first electrode 110 in a direction perpendicular to the first substrate 101 and the third portion may overlap the second electrode 130 in a direction perpendicular to the first substrate 101. The oxide semiconductor layer 120 may correspond to an oxide semiconductor thin film described above.

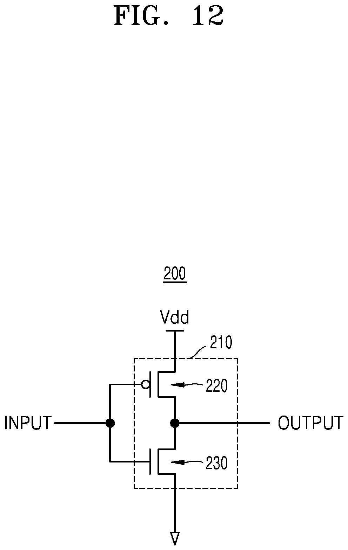

FIG. 12 is a circuit diagram illustrating a complementary metal-oxide-semiconductor (CMOS) inverter 200 according to some example embodiments.

The CMOS inverter 200 includes a CMOS transistor 210. The CMOS transistor 210 includes a P-channel MOS (PMOS) transistor 220 and an N-channel MOS (NMOS) transistor 230 connected between a power supply terminal Vdd and a ground terminal. The CMOS transistor 210 may include a semiconductor device according to various example embodiments described with reference to FIGS. 7 to 11.

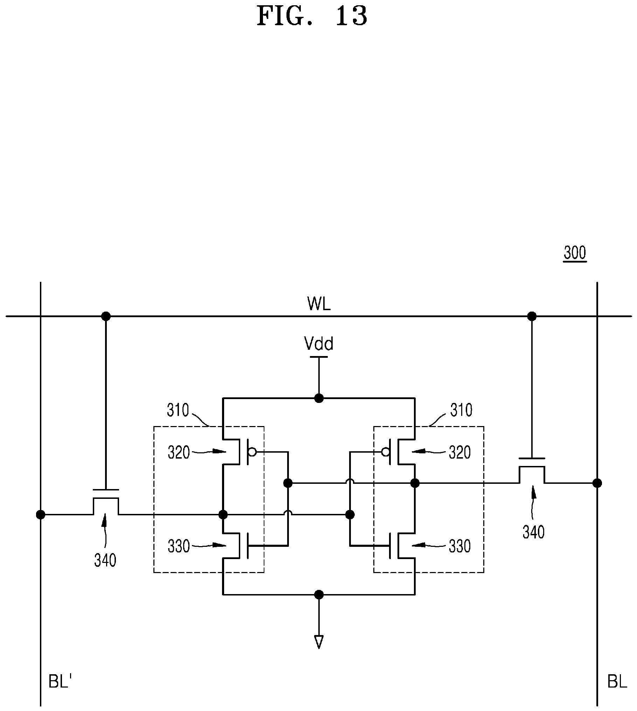

FIG. 13 is a circuit diagram illustrating a CMOS static random-access memory (SRAM) device 300 according to some example embodiments.

The CMOS SRAM device 300 includes one pair of driving transistors 310. Each driving transistor 310 includes a PMOS transistor 320 and an NMOS transistor 330 connected between a power supply terminal Vdd and a ground terminal. The CMOS SRAM device 300 may further include one pair of transfer transistors 340. A source of the transfer transistor 340 is cross-connected to a common node of the PMOS transistor 320 and the NMOS transistor 330 constituting the driving transistor 310. The power supply terminal Vdd is connected to a source of the PMOS transistor 320, and the ground terminal is connected to a source of the NMOS transistor 330. A word line WL may be connected to gates of the one pair of transfer transistors 340, and a bit line BL and an inverted bit line BL' may be respectively connected to drains of the one pair of transfer transistors 340.

At least one of the driving transistor 310 and the transfer transistor 340 of the CMOS SRAM device 300 may include a semiconductor device according to various example embodiments described with reference to FIGS. 7 to 11.

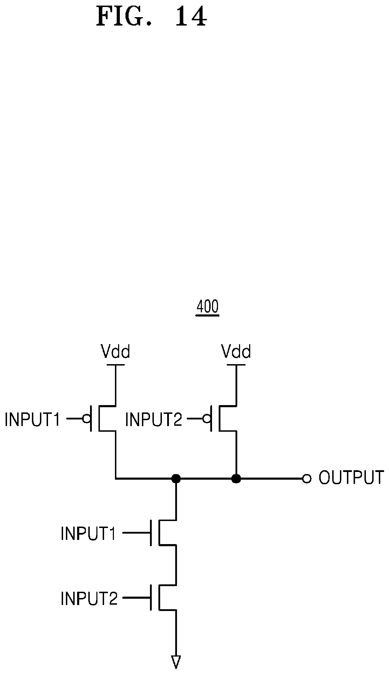

FIG. 14 is a circuit diagram illustrating a CMOS NAND circuit 400 according to some example embodiments.

The CMOS NAND circuit 400 includes one pair of CMOS transistors to which different input signals are transmitted. The CMOS NAND circuit 400 may include a semiconductor device according to various example embodiments described with reference to FIGS. 7 to 11.

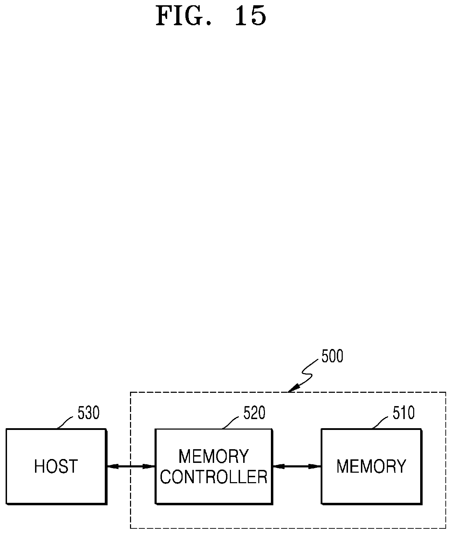

FIG. 15 is a block diagram illustrating an electronic system 500 according to various example embodiments.

The electronic system 500 includes a memory 510 and a memory controller 520. The memory controller 520 may control data to be read from the memory 510 and/or data to be written to the memory 510 in response to a request of a host 530. At least one of the memory 510 and the memory controller 520 may include a semiconductor device according to various example embodiments described with reference to FIGS. 7 to 11.

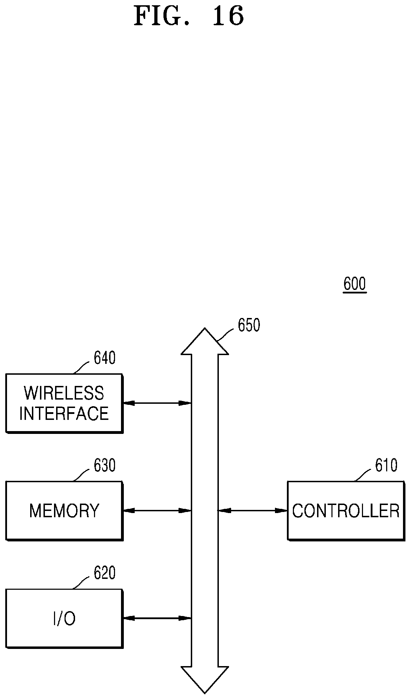

FIG. 16 is a block diagram illustrating an electronic system 600 according to various example embodiments.

The electronic system 600 may constitute a wireless communication device or a device capable of transmitting and/or receiving information in a wireless environment. The electronic system 600 may include a controller 610, an input/output (I/O) device 620, a memory 630, and a wireless interface 640, which are connected to each other through a bus 650.

The controller 610 may include at least one of a microprocessor, a digital signal processor, or a processing device similar thereto. The I/O device 620 may include at least one of a keypad, a keyboard, or a display. The memory 630 may be used to store a command executed by the controller 610. For example, the memory 630 may be used to store user data. The electronic system 600 may use the wireless interface 640 to transmit/receive data through a wireless communication network. The wireless interface 640 may include an antenna and/or a wireless transceiver. The electronic system 600 may include a semiconductor device according to various example embodiments described with reference to FIGS. 7 to 11.

A semiconductor device according to some example embodiments may exhibit good electrical performance with an ultra-small structure and may thus be applied to an integrated circuit device and may achieve miniaturization, low power consumption, and high performance.

While a semiconductor thin film, a semiconductor device, and an electronic device including the same have been described with reference to the various example embodiments shown in the drawings, these are examples, and it will be understood by one of ordinary skill in the art that various changes in form and details may be made therein without departing from the scope of the disclosure. Although many matters have been described in detail in the above description, they should be interpreted as examples of specific example embodiments rather than limiting the scope of the disclosure. The scope of the disclosure should not be defined by the above example embodiments but should be defined by the following claims.

When a semiconductor device according to some example embodiments uses an amorphous oxide semiconductor including tin as a main component as a channel material, Hall mobility may increase. Hence, sub-threshold swing of the semiconductor device may be reduced.

An amorphous oxide semiconductor including tin as a main component according to some example embodiments is a semiconductor material having a wide band gap and may be used in a highly integrated memory device or logic device.

It should be understood that example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by one of ordinary skill in the art that various changes in form and details may be made therein without departing from the spirit and scope as defined by the following claims.

## Claims

1. A semiconductor device comprising:
an oxide semiconductor layer having an amorphous phase and comprising tin (Sn) and a metal element other than tin (Sn), wherein a content of tin (Sn) is greater than 50 at% of a total content of tin (Sn) and the metal element other than tin (Sn);
a first electrode and a second electrode on the oxide semiconductor layer and spaced apart from each other;
a gate electrode spaced apart from the oxide semiconductor layer; and
a gate insulating layer between the oxide semiconductor layer and the gate electrode.

2. The semiconductor device of claim 1, wherein the metal element other than tin comprises at least one of indium (In), gallium (Ga), zinc (Zn), aluminum (Al), or hafnium (Hf).

3. The semiconductor device of claim 1 or 2, wherein the metal element other than tin (Sn) comprises zinc (Zn), wherein a content of zinc (Zn) is 10 at% or less.

4. The semiconductor device of any preceding claim, wherein, in the oxide semiconductor layer, a content of zinc (Zn) is 0 at%.

5. The semiconductor device of any preceding claim, wherein the content of tin is less than 80 at%.

6. The semiconductor device of any preceding claim, wherein the oxide semiconductor layer has an amorphous phase at 350°C to 700°C.

7. The semiconductor device of any preceding claim, wherein the metal element other than tin comprises indium,
wherein a content ratio of tin to indium is greater than 1 and less than or equal to 4.

8. The semiconductor device of claim 7, wherein a content of indium is 20 at% or more.

9. The semiconductor device of any preceding claim, wherein wherein the metal element other than tin comprises gallium, wherein
a content of gallium is 30 at% or less.

10. The semiconductor device of any one of claim 1 to 8, wherein
wherein the metal element other than tin comprises indium (In) and gallium (Ga), and a content of gallium is 30 at% or less.
and optionally wherein a content of indium is 20 at% or more.

11. The semiconductor device of any preceding claim, wherein the oxide semiconductor layer has Hall mobility of 15 cm²/Vs or more.

12. The semiconductor device of any preceding claim, wherein the oxide semiconductor layer has resistivity of 10⁻¹ Ωcm or less.

13. The semiconductor device of any preceding claim, wherein the oxide semiconductor layer has a thickness of 20 nm or less.

14. The semiconductor device of any preceding claim, wherein the gate insulating layer comprises at least one of hafnium (Hf), zirconium (Zr), aluminum (Al), or silicon (Si).

15. The semiconductor device of claim 1, wherein the gate electrode comprises at least one of metal, metal nitride, or transparent conductive oxide (TCO).
